# EUROPEAN PATENT APPLICATION

(11) **EP 4 788 092 A1**
(43) Date of publication of application: **05.08.2026**
(21) Application number: 24872594.7
(22) Date of filing: 30.09.2024
(51) Int. Cl.: H10F 30/20

(54) **INFRARED SENSOR, NANOMATERIAL, DISPERSION, AND METHOD FOR MANUFACTURING INFRARED SENSOR**

(30) Priority: 29.09.2023 JP 2023170555
(71) Applicant: Toppan Holdings Inc., Tokyo 110-0016 (JP)
(72) Inventor: MIYANAGA, Akiharu, Tokyo 110-0016 (JP); ITO, Tetsuji, Tokyo 110-0016 (JP); WATANABE, Mayuko, Tokyo 110-0016 (JP)
(74) Representative: TBK
(86) International application number: PCT/JP2024/034952
(87) International publication number: WO 2025/070815

(57) **Abstract**

To provide an infrared sensor capable of selecting a preferred combination of materials for an electron transport layer and a hole transport layer and a method for producing the infrared sensor. An infrared sensor of the present invention is an infrared sensor including an electron transport layer, a light absorption layer and a hole transport layer, wherein the light absorption layer contains quantum dots, the electron transport layer contains at least one of ZnO, MgZnO and SnO, and the hole transport layer contains at least one of NiO and MoO. In the present invention, oxidation deficiency in a metal oxide constituting the electron transport layer and the hole transport layer is preferably smaller than that in a bulk material.

## Description

### [Technical Field]

The present invention relates to an infrared sensor having a light absorption layer that absorbs infrared radiation.

### [Background Art]

PTL 1 below discloses a photoelectric conversion element having a photoelectric conversion layer that performs photoelectric conversion upon receiving light in the near-infrared region.

In the photoelectric conversion element, a transparent electrode, an electron transport layer, a photoelectric conversion layer, a hole transport layer, and a metal electrode are stacked in this order.

### [Citation List]

### [Patent Literature]

PTL 1: JP 2021-012906 A

### [Summary of Invention]

### [Technical Problem]

However, the invention disclosed in PTL 1 does not describe any preferred combination of materials for the electron transport layer and the hole transport layer in relation to the absorption edge.

The present invention has been made in view of this point, and aims to provide an infrared sensor capable of selecting a preferred combination of materials for an electron transport layer and a hole transport layer.

### [Solution to Problem]

The present invention is an infrared sensor including an electron transport layer, a light absorption layer and a hole transport layer, wherein the light absorption layer contains quantum dots, the electron transport layer contains at least one of ZnO, MgZnO and SnO, and the hole transport layer or a hole extraction layer contains at least one of NiO and MoO.

The present invention is a material for use in an electron transport layer constituting the infrared sensor described above, wherein a slope of a Tauc plot of the material at an absorption edge is greater than that of a bulk material.

The present invention is a dispersion liquid of the material described above, wherein the dispersion liquid has a polydispersity index of less than 0.1 in DLS measurement.

### [Advantageous Effects of Invention]

An infrared sensor according to the present invention can achieve a steeper absorption edge by using a combination of materials constituting an electron transport layer and a hole transport layer.

### [Brief Description of Drawings]

Fig. 1 is a perspective view of an infrared imaging device having an infrared sensor according to the present embodiment.
Fig. 2 is a partial cross-sectional view of an infrared sensor according to the present embodiment.
Fig. 3 shows schematic diagrams of a quantum dot according to the present embodiment.
Fig. 4 shows energy level diagrams in which quantum dots having a core-shell structure are used.
Fig. 5 is a synthesis flow of ZnO.
Fig. 6 is a synthesis flow of MgZnO.
Fig. 7 is a synthesis flow of SnOx.
Fig. 8 is a synthesis flow of NiOx.
Fig. 9 is a synthesis flow of MoOx.
Fig. 10A is a graph illustrating a UV spectrum, and Fig. 10B is a graph illustrating band gap energy.
Fig. 11 is a synthesis flow of NiO.
Fig. 12 illustrates XRD for NiO.
Fig. 13 illustrates a UV spectrum of NiO.
Fig. 14 is a graph (Tauc plot) illustrating band gap energy of NiO.
Fig. 15 is an XANES spectrum in an evaluation of Ni valence.
Fig. 16 is a graph illustrating relationships between particle size and scattering intensity distribution in Examples 1 to 3.

### [Description of Embodiments]

In the following description, one embodiment of the present invention (hereinafter, also referred to as an "embodiment") will be described in detail. The present invention is not limited to the following embodiment, and various modifications can be made within the scope of the present invention.

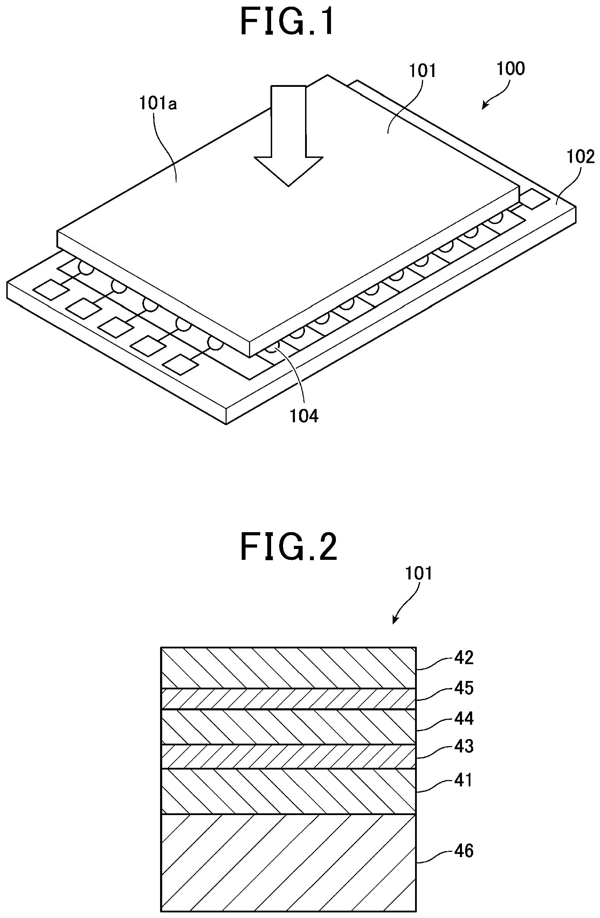

Fig. 1 is a perspective view of an infrared imaging device having an infrared sensor according to the present embodiment. As shown in Fig. 1, an infrared imaging device 100 includes an infrared sensor 101 and a circuit substrate 102.

As shown in Fig. 1, the infrared sensor 101 is flip-chip bonded to the circuit substrate 102 via a plurality of bumps 104.

For example, the infrared sensor 101 may include a QDIP (Quantum Dot Infrared Photodetector) array in which a plurality of pixels are arranged. The bumps 104 are provided for each pixel. In the present embodiment, the number of pixels is not specified.

A surface 101a of the infrared sensor 101 shown in Fig. 1 is a light-receiving surface, and when infrared radiation is irradiated in the direction of the arrow, carriers confined within the quantum dots in the infrared sensor 101 are excited, and the infrared radiation is detected as a photocurrent on the circuit substrate 102 side.

The present embodiment can provide an image sensor capable of detecting infrared radiation. Although the infrared imaging device 100 of the present embodiment is not limited to specific applications, it may be applied to, for example, night vision devices, heat source detection devices, security devices, medical equipment, and the like.

Fig. 2 is a partial cross-sectional view showing an example of an infrared sensor (photoelectric conversion element) according to the present embodiment. The infrared sensor 101 shown in Fig. 2 includes a first conductive layer 41 as a cathode and a second conductive layer 42 as an anode, and further includes an electron transport layer 43, a light absorption layer 44 and a hole transport layer 45 between the first conductive layer 41 and the second conductive layer 42. For example, the first conductive layer 41 may be disposed on a glass substrate 46. An electron extraction layer may be provided.

In this embodiment, the electron transport layer 43 preferably contains at least one of ZnO, MgZnO and SnO. The hole transport layer 45 (or hole extraction layer) preferably contains at least one of NiO and MoO.

Further, in this embodiment, the oxidation deficiency in the metal oxide constituting the electron transport layer 43 and the hole transport layer 45 (or hole extraction layer) is preferably smaller than that in a bulk material. That is, a stoichiometric composition is preferred. According to the synthesis flow of the metal oxide of this embodiment, oxidation deficiency can be suppressed.

The "bulk material" refers to a mass including the metal oxide and may have any size and any shape.

In this embodiment, the light absorption layer 44 is a layer that absorbs light incident on the infrared sensor 101 and generates electrons and holes.

The light absorption layer 44 contains quantum dots. A large number of quantum dots are dispersed in the light absorption layer 44.

The quantum dots are preferably spherical. The "spherical" herein is not limited to a perfect sphere, but refers to a shape satisfying the condition of sphericity of 0.7 or greater, preferably 0.8 or greater, and more preferably 0.9 or greater. The sphericity can be measured, for example, by performing image processing with an electron microscope, and calculating 4π × (area) ÷ (circumference) 2 from the area and circumference of the observed quantum dots. Alternatively, the quantum dots can be defined as "spherical" when the aspect ratio of the observed quantum dots expressed as the major axis/minor axis is 1.5 or less, preferably 1.3 or less, and more preferably 1.2 or less.

In the present embodiment, the quantum dots can be formed by liquid phase synthesis. The quantum dots of the present embodiment are preferably spherical as described above, but are not limited thereto. The quantum dots synthesized by liquid phase synthesis may be spherical as described above or may be formed in a shape other than spherical. Examples of shapes other than spherical include rod-like and dendritic shapes.

For example, in the present embodiment, the light absorption layer 44 can be formed using a resin composition obtained by dispersing a plurality of spherical quantum dots in a resin. The dispersion resin for quantum dots is not specifically limited, and examples thereof include polypropylene, polyethylene, polystyrene, AS resin, ABS resin, methacrylic resin, polyvinyl chloride, polyacetal, polyamide, polycarbonate, modified polyphenylene ether, polybutylene terephthalate, polyethylene terephthalate, polysulfone, polyethersulfone, polyphenylene sulfide, polyamideimide, polymethylpentene, liquid crystal polymer, epoxy resin, phenolic resin, urea resin, melamine resin, epoxy resin, diallyl phthalate resin, unsaturated polyester resin, polyimide, polyurethane, silicone resin, cyclic polyolefin polymer (Cyclic Olefin Polymer: COP), cyclic polyolefin copolymer (Cyclic Olefin Copolymer: COC), ethylene vinyl alcohol, polymethylpentene, polyvinylidene fluoride, and the like.

Alternatively, in the present embodiment, a plurality of spherical quantum dots dissolved in a solvent can be applied by an inkjet method. In this case, the dried quantum dot layer is substantially composed of spherical quantum dots, but a small amount of solvent components may remain in the quantum dot layer.

The quantum dots have an emission wavelength of about 800 nm to 1,600 nm. The quantum dots having such an emission wavelength preferably include at least one of PbS, PbSe, CdHgTe, Ag₂S, Ag₂Se, Ag₂Te, AgInSe₂, AgInTe₂, CuInSe₂, CuInTe₂ and InAs. Of these, Ag₂S is not subject to the RoHS directive. Regarding PbS, a paper has been published in 2003 WILEY-VCH Verlag GmbH & Co. KGaA. Weinheim. ADVANCED MATERIALS 2003, 15. NO.21 November 4. Further, regarding Ag₂S, a paper has been published in ACS NANO VOL.6 NO.5 P3695-3702 (2012).

In the present embodiment, PbS or Ag₂S is preferably used for the quantum dots. Further, using Ag₂S, Ag₂Se, Ag₂Te, AgInSe₂ or AgInTe₂ for the quantum dots can narrow the fluorescence half-width in the near-infrared region, thereby exhibiting high-intensity near-infrared fluorescence.

In the present embodiment, a plurality of quantum dots may be of one type or two or more types. That is, the plurality of quantum dots may all be of the same type, or may be of different types.

The quantum dots of the present embodiment may be, for example, nanoparticles having a particle size of about several nm to several tens of nm.

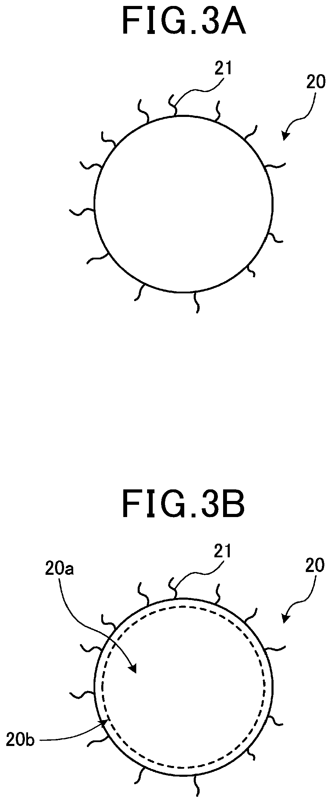

As illustrated in Fig. 3A, a large number of organic ligands 21 are preferably coordinated to the surface of the quantum dot 20. This makes it possible to prevent the quantum dots 20 from aggregating together, thereby exhibiting desired optical characteristics. Ligands usable for reaction are not specifically limited, and typical examples thereof include the following ligands.

(1) Aliphatic primary amines
   Oleylamine: C₁₈H₃₅NH₂, stearyl (octadecyl) amine: C₁₈H₃₇NH₂, dodecyl (lauryl) amine: C₁₂H₂₅NH₂, decylamine: C₁₀H₂₁NH₂, and octylamine: C₈H₁₇NH₂
(2) Fatty acids
   Oleic acid: C₁₇H₃₃COOH, stearic acid: C₁₇H₃₅COOH, palmitic acid: C₁₅H₃₁COOH, myristic acid: C₁₃H₂₇COOH, lauric acid: C₁₁H₂₃COOH, decanoic acid: C₉H₁₉COOH, and octanoic acid: C₇H₁₅COOH
(3) Thiols
   Octadecanethiol: C₁₈H₃₇SH, hexadecanethiol: C₁₆H₃₃SH, tetradecanethiol: C₁₄H₂₉SH, dodecanethiol: C₁₂H₂₅SH, decanethiol: C₁₀H₂₁SH, and octanethiol: C₈H₁₇SH
(4) Phosphines
   Trioctylphosphine: (C₈H₁₇)₃P, triphenylphosphine: (C₆H₅)₃P, and tributylphosphine: (C₄H₉)₃P
(5) Phosphine oxides
   Trioctylphosphine oxide: (C₈H₁₇)₃P=O, triphenylphosphine oxide: (C₆H₅)₃P=O, and tributylphosphine oxide: (C₄H₉)₃P=O

In the present embodiment, a short ligand is preferably used for the organic ligand 21. The organic ligand 21 may be, but is not limited to, 3-mercaptopropionic acid (MPA).

A ligand on each of the quantum dots 20 contained in a quantum dot layer is preferably shorter than a ligand used when the quantum dot 20 is formed by solution phase synthesis.

Using short ligands for ligands on the quantum dots 20 contained in the quantum dot layer can reduce the roughness of the quantum dot layer and improve the extraction efficiency of electrons and holes. On the other hand, using long ligands for the quantum dots 20 formed by liquid phase synthesis can improve the dispersibility and film-forming properties.

Alternatively, after quantum dots 20 having long ligands are synthesized by solution phase synthesis, the long ligands may be replaced with short ligands (e.g., 3-mercaptopropionic acid) before or after a composition containing the quantum dots 20 is applied.

Further, as illustrated in Fig. 3B, the quantum dot 20 may have a core-shell structure having a core 20a and a shell 20b covering the surface of the core 20a. As illustrated in Fig. 3B, a large number of organic ligands 21 are preferably coordinated to the surface of the quantum dot 20. The organic ligands 21 are as described above. The core 20a of the quantum dot 20 illustrated in Fig. 3B is the nanoparticle illustrated in Fig. 3A. Therefore, the core 20a may be formed of, for example, the material of the quantum dots 20 described above.

The shell 20b may be present in solid solution on the surface of the core 20a. Fig. 3B illustrates the boundary between the core 20a and the shell 20b using a dotted line, but this means that it does not important whether the boundary between the core 20a and the shell 20b can be confirmed by analysis. In addition, although not shown, a buffer layer may preferably be provided between the core 20a and the shell 20b. The buffer layer is a region in which at least some or all of elements constituting the core 20a and at least some or all of elements constituting the shell 20b coexist.

The present embodiment has a configuration coated with spherical quantum dots, and for example, by using quantum dots (in particular, spherical quantum dots) formed by liquid phase synthesis, the sensitivity can be excellent in all directions, reducing variation in sensitivity compared to, for example, microfabricated quantum dots.

Further, in the present embodiment, the quantum dots preferably include at least one of PbS, PbSe, CdHgTe, Ag₂S, Ag₂Se, Ag₂Te, AgInSe₂, AgInTe₂, CuInSe₂, CuInTe₂ and InAs. These have an emission wavelength of 800 nm to 1,600 nm, and can be suitably applied to infrared sensors.

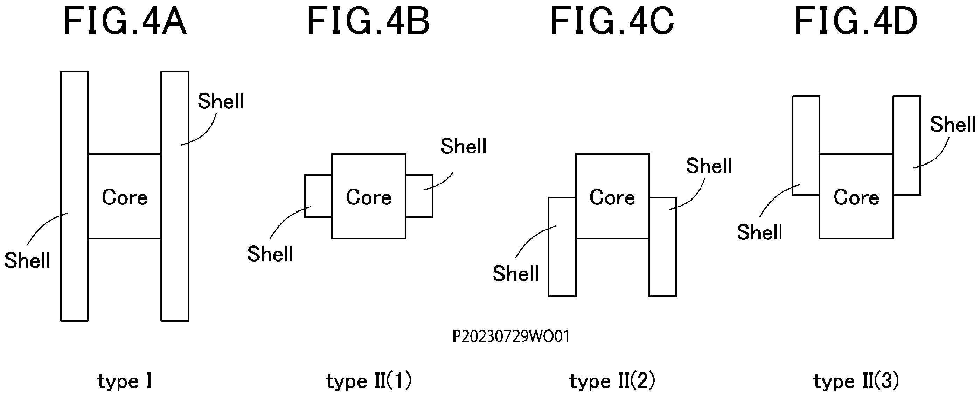

When the quantum dots applied to this embodiment have a core-shell structure, the energy level diagram will be one of those shown in Figs. 4A to 4D. Of these, in the case of a light-emitting element, the shell of the core-shell structure is important in terms of improving the quantum confinement effect. In particular, the type I structure shown in Fig. 4A (where the shell LUMO has higher energy than the core LUMO, and the shell HOMO has lower energy than the core HOMO) is preferred.

On the other hand, when used in a photoelectric conversion element as in this embodiment, the type II structure is preferred so that carriers (electrons and holes) can be easily extracted, and the type II (1) or (3) may preferably be selected since hole mobility is usually lower than electron mobility. Further, when used in a photoelectric conversion element, quantum dots having a core structure having ligands can be used instead of the core-shell structure. In the type II (1), the shell LUMO has lower energy than the core LUMO, and the shell HOMO has higher energy than the core HOMO. In the type II (3), the shell LUMO has higher energy than the core LUMO, and the shell HOMO has lower energy than the core HOMO.

In this embodiment, the film thickness of the light absorption layer is preferably 5 nm or greater and 50 nm or less.

### (Electron Transport Layer 43)

The electron transport layer 43 includes an inorganic substance or an organic substance having a function of transporting electrons. In this embodiment, the electron transport layer 43 contains at least one of ZnO, MgZnO and SnO. It is also possible to select two or more of these. The electron transport layer 43 is particularly preferably formed of ZnO_{X} nanoparticles. In addition, a metal oxide may be doped with Li, Mg, Al, Mn, or the like. X is not limited, but may be about 0.8 to 1.2, and having no oxidation deficiency is preferred.

As with the light absorption layer 44, the electron transport layer 43 can be formed by applying a solvent containing nanoparticles by a printing method such as an inkjet method or can be formed by an existing thin-film technology such as a vacuum deposition method.

### (Hole Transport Layer 45 or Hole Extraction Layer)

The hole transport layer 45 includes an inorganic substance or an organic substance having a function of transporting holes. In this embodiment, the hole transport layer 45 or a hole extraction layer preferably contains at least one of NiO and MoO. The hole transport layer 45 or a hole extraction layer may contain, for example, NiO mixed with Al₂O₃ or the like. In addition, a metal oxide may be doped with Li, Mg, Al, or the like. The metal oxide constituting the hole transport layer 45 or a hole extraction layer preferably has no oxidation deficiency.

The method for producing an infrared sensor of this embodiment includes forming spherical quantum dots by liquid phase synthesis, and applying a resin composition containing the quantum dots to form a light absorption layer.

In this embodiment, as a liquid phase synthesis method, the source of each element constituting the quantum dots is dissolved in a solvent, and a precursor solution containing each element is reacted using, for example, a microreactor, whereby quantum dot particles containing a predetermined element can be synthesized. Thus, spherical quantum dots can be obtained.

In order to improve the dispersibility of the quantum dots, it is preferred to use long-chain ligands. Therefore, quantum dots having long-chain ligands are preferred for coating, but short-chain ligands are preferred for production of devices to enhance the extraction efficiency of carriers (electrons and holes). The number of carbon atoms of the short-chain ligands is not limited, but may be 2 to 5 (preferably 2 to 3). For example, 3-mercaptopropionic acid can be used for the short-chain ligands.

In this embodiment, after the quantum dots are synthesized by liquid phase synthesis, the ligands of the quantum dots can be replaced with short ligands. In one example, a composition containing quantum dots (containing quantum dots and a solvent) is applied using a spin coater. Long-chain ligands have better dispersibility and can form a film having good roughness, but long-chain ligands are disadvantageous in extraction of carriers. Therefore, for example, after coating, short-chain ligands can be dripped onto the coating film. Accordingly, the long-chain ligands are spontaneously replaced with short-chain ligands, and the long-chain ligands are then washed away by washing. Alternatively, after the quantum dots are synthesized by liquid phase synthesis, long-chain ligands can be replaced with short-chain ligands before coating, and then a composition (which may be a resin composition) containing the quantum dots can be applied.

In this embodiment, the electron transport layer 43 is formed using ZnO, MgZnO or SnO. In the following description, synthesis flows of these metal oxides will be described.

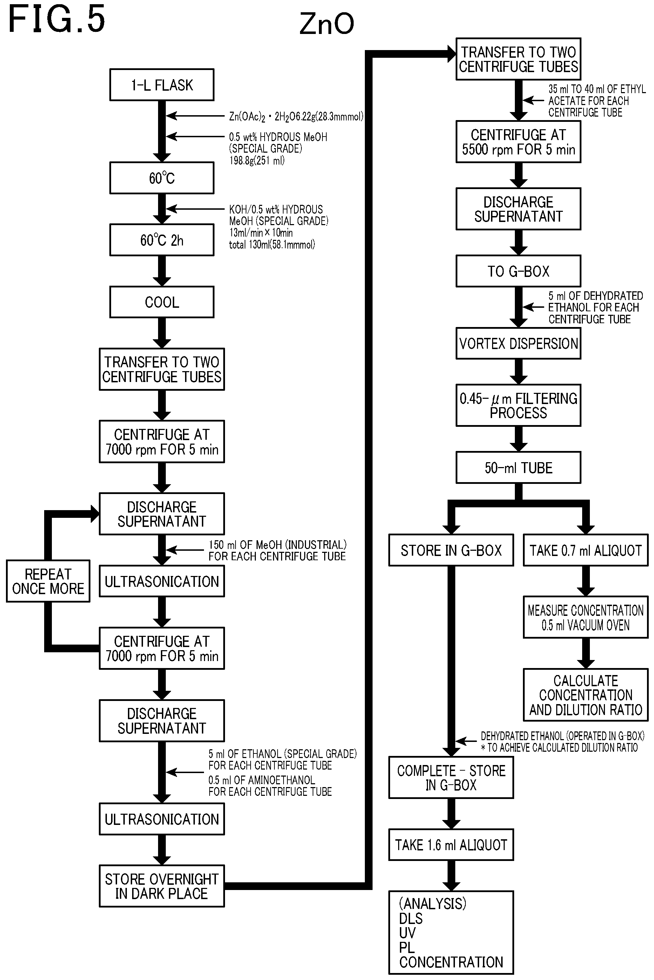

Fig. 5 is a synthesis flow of ZnO. As shown in Fig. 5, Zn(OAc)₂·2H₂O (6.22 g, 28.3 mmol) and 0.5 wt% hydrous methanol (198.8 g, 251 ml) were mixed in a flask and the temperature thereof was raised to 60°C.

Next, KOH/0.5 wt% hydrous methanol was added to the flask at a rate of 13 ml per minute and this addition was continued for ten minutes. The temperature of 60°C was maintained for two hours.

Next, the contents of the flask were transferred to two centrifuge tubes after being cooled, and were centrifuged under conditions of 7,000 rpm for five minutes. Next, the supernatant liquids of the respective centrifuge tubes were discharged and the centrifuge tubes were subjected to ultrasonic waves, after which they were centrifuged again under conditions of 7,000 rpm for five minutes. The steps of discharging the supernatant liquids → ultrasonication → centrifugation were repeated once more.

Next, the steps of discharging the supernatant liquids → ultrasonication were performed, and ethanol (5 ml) and aminoethanol (0.5 ml) were added to each of the centrifuge tubes between the steps of discharging the supernatant liquids and ultrasonication. Then, the centrifuge tubes were stored overnight in a dark place.

Next, the contents of the centrifuge tubes were transferred to another two centrifuge tubes and then about 35 ml to 40 ml of ethyl acetate was added to each of the centrifuge tubes, which were then centrifuged under conditions of 5,500 rpm for five minutes. The supernatant liquids of the respective centrifuge tubes were then discharged and each of the centrifuge tubes was transferred to a G-BOX and dispersed using a vortex mixer.

Next, the contents of each of the centrifuge tubes were transferred to a 50-ml tube through a 0.54-µm filter. A 0.7 ml aliquot was taken therefrom and the remainder was stored in the G-BOX. A concentration measurement was made using the 0.7 ml aliquot, to calculate the concentration and the dilution ratio. Based on the calculation, the dilution ratio was adjusted to the calculated value using dehydrated ethanol in the G-BOX. Then, the completed G-BOX was stored. A 1.6 ml aliquot was taken from this completed G-BOX and the DLS, the UV value, the PL value and the concentration were analyzed.

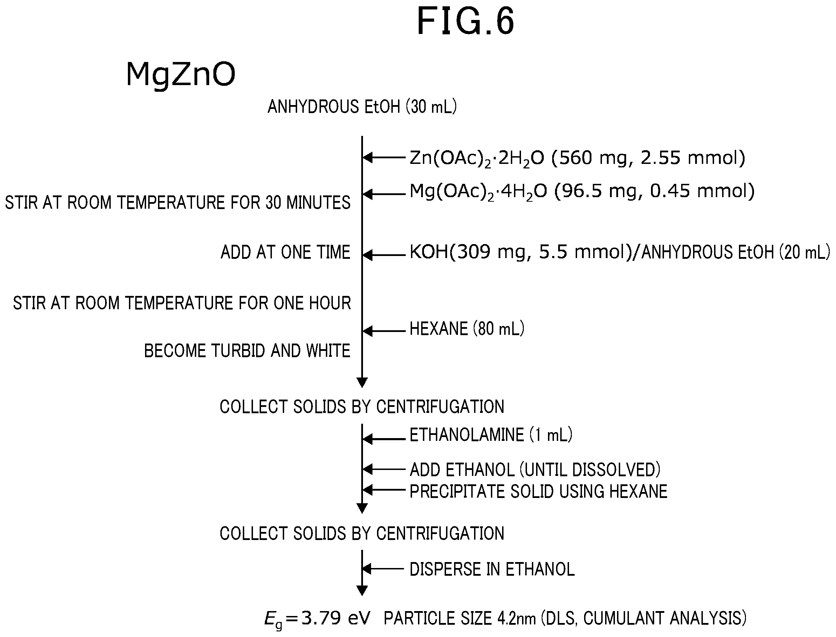

Fig. 6 is a synthesis flow of MgZnO. As shown in Fig. 6, first, anhydrous ethanol (30 mL) was prepared, and Zn(OAc)₂·2H₂O (560 mg, 2.55 mmol) and Mg (OAc)₂·4H₂O (96.5 mg, 0.45 mmol) were added thereto, followed by stirring at room temperature for 30 minutes. Next, KOH (309 mg, 5.5 mmol)/anhydrous ethanol (20 mL) was added. The mixture was then stirred at room temperature for 1 hour. Next, hexane (80 mL) was added. This caused the mixture solution to become turbid and white. Ethanolamine (1 mL) was added to the mixed solution until dissolved. Hexane was further added to precipitate solids, which were then dispersed in ethanol. This yielded MgZnO having a particle size of about 4.2 nm. Band gap energy E_{g} of the MgZnO was 3.79 eV.

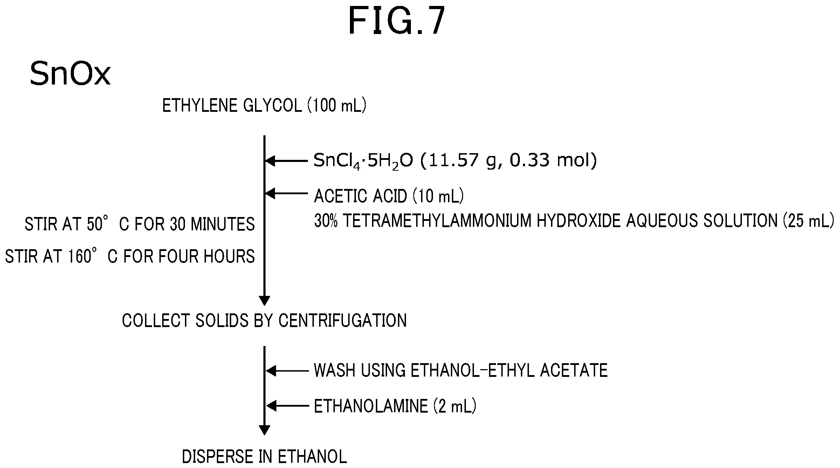

Fig. 7 is a synthesis flow of SnOx. As shown in Fig. 7, ethylene glycol (100 mL) was prepared, and SnCl₄·5H₂O (11.57 g, 0.33 mol), acetic acid (10 mL) and a 30% tetramethylammonium hydroxide aqueous solution (25 mL) were mixed therewith, followed by stirring at 50°C for 30 minutes. Next, the temperature was increased to 160°C and the mixture was stirred for 4 hours.

Next, washing was performed using ethanol-ethyl acetate, and 2 ml of ethanolamine was added for dispersion in ethanol.

In this embodiment, the hole transport layer 45 or a hole extraction layer was formed using NiO or MoO. In the following description, synthesis flows of these metal oxides will be described.

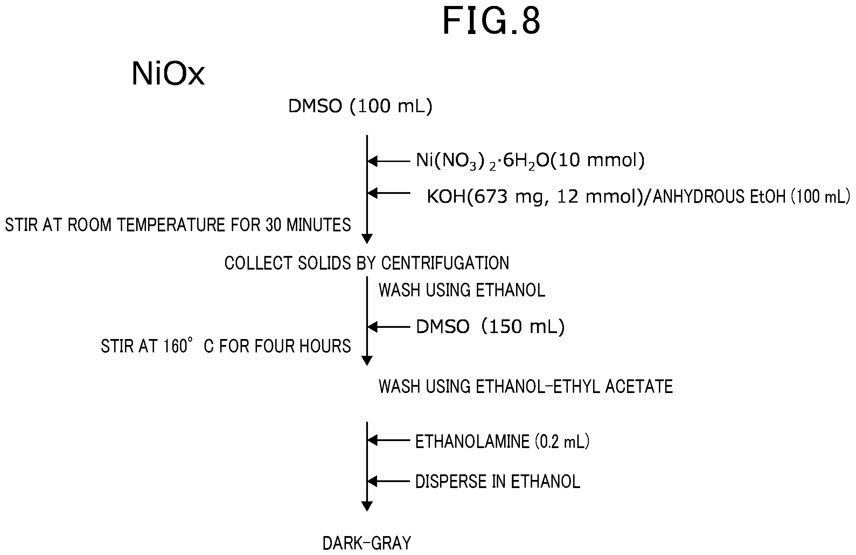

Fig. 8 is a synthesis flow of NiOx. As shown in Fig. 8, DMSO (100 mL) was prepared, and Ni(NO₃)₂·6H₂O (10 mmol) and KOH (673 mg, 12 mmol)/anhydrous ethanol (100 mL) were mixed therewith, followed by stirring at room temperature for 30 minutes. Next, after washing was performed using ethanol, DMSO (150 mL) was added, followed by stirring at a temperature of 160°C for 4 hours. Next, washing was performed using ethanol-ethyl acetate, and ethanolamine (0.2 mL) was added for dispersion in ethanol. This yielded a dark-gray precipitate.

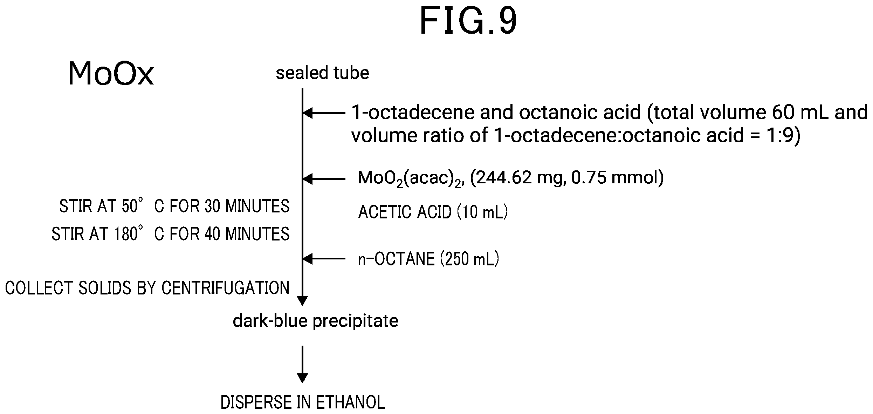

Fig. 9 is a synthesis flow of MoOx. 1-octadecene and octanoic acid (a total volume of 60 mL, a volume ratio of 1-octadecene : octanoic acid = 1:9), MoO₂(acac)₂ (244.62 mg, 0.75 mmol), and acetic acid (10 mL) were mixed in a sealed tube, followed by stirring at 50°C for 30 minutes. Next, the temperature was increased to 180°C and stirring was performed for 40 minutes. n-octane (250 mL) was added to obtain a dark-blue precipitate. The precipitate was dispersed in ethanol.

According to the synthesis flows of the present embodiment, metal oxides having no oxidation deficiency can be obtained. The use of the electron transport layer and the hole transport layer according to the present embodiment effectively allows the absorption edge of the infrared region to be steeper.

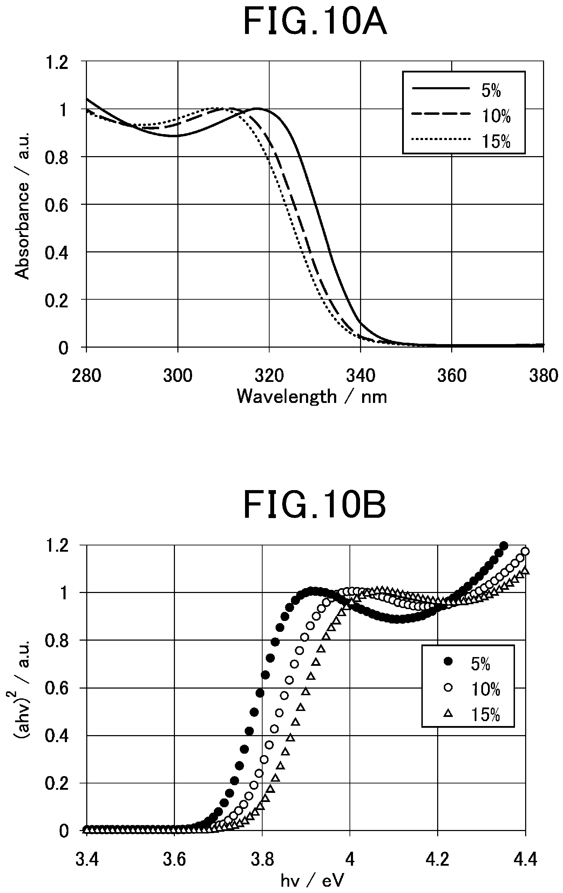

Fig. 10A is a graph showing the UV spectrum, and Fig. 10B is a graph (Tauc plot) showing band gap energy. In the experiment, the Mg doping amount in MgZnO was varied. The MgZnO used in the experiment was as-synthesized MgZnO dispersed in DEGME. As shown in Fig. 10, it was found that the band gap energy E_{g} increased as the Mg doping amount increased.

**[Table 1]**

| dope | Std (0%) | Mg 5% | Mg 10% | Mg 15% |
|---|---|---|---|---|
| E_{g}/eV | 3.48 | 3.71 | 3.75 | 3.79 |

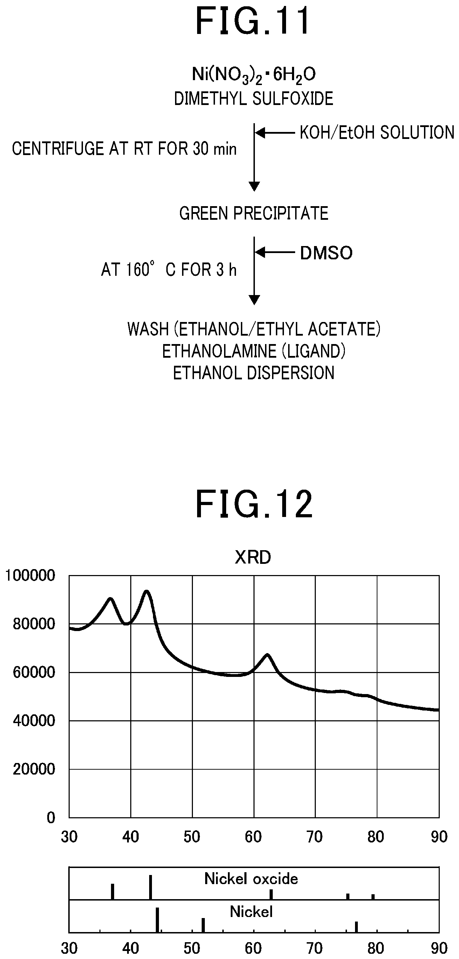

Fig. 11 is a synthesis flow of NiO. The drawing shows a synthesis flow different from that of Fig. 8. That is, as shown in Fig. 11, Ni(NO₃)₂·6H₂O, a dimethyl sulfoxide, and a KOH/anhydrous ethanol solution were mixed and stirred at room temperature for 30 minutes. This yielded a green precipitate. This was mixed with DMSO, maintained at a temperature of 160°C for 3 hours, and washed using ethanol/ethyl acetate. Next, ethanolamine was added for dispersion in ethanol.

Fig. 12 shows the XRD for NiO. The NiO used in the experiment was obtained in the synthesis flow of Fig. 11. As shown in Fig. 12, NiO was observed. On the other hand, Ni was not observed, and it was found that appropriate synthesis was performed.

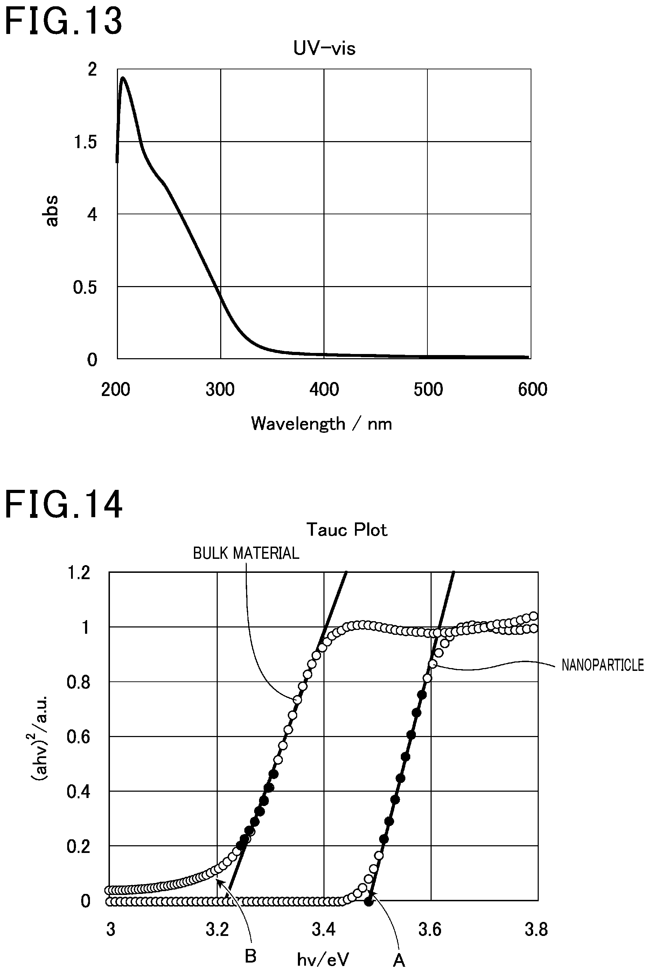

Fig. 13 shows the UV spectrum of NiO, and Fig. 14 is a graph (Tauc plot) showing band gap energy.

As shown in Fig. 14, it was found that the slope of the Tauc plot at the absorption edge was greater than that of the bulk material. It was found that this allowed the absorption edge to be steeper. Further, as shown in Fig. 14, it was found that the nanoparticles had a smaller and steeper rise in the tail of the Tauc plot compared to the bulk material. Since all electron transport materials in this example were semiconductors, the slope of the Tauc plot was larger for all electron transport materials compared to the bulk material.

Furthermore, as shown in Figure 14, it was found that, among regions A and B enclosed by the tangent line representing the slope, the plotted curve, and the horizontal axis, the region A for the nanoparticles was smaller than the region B for the bulk material. The smaller the region, the smaller the oxidation deficiency, and thus it was proved that the nanoparticles had smaller oxidation deficiency than the bulk material.

### <Ni Valence of NiO>

Using standard samples having known valences (NiO: divalent and LiNiO₂: trivalent), a calibration curve for the onset position of the XANES spectrum and Ni valence was created. In the experiment, BL08W was used as the beam line, and a transmission method was used as the measurement method.

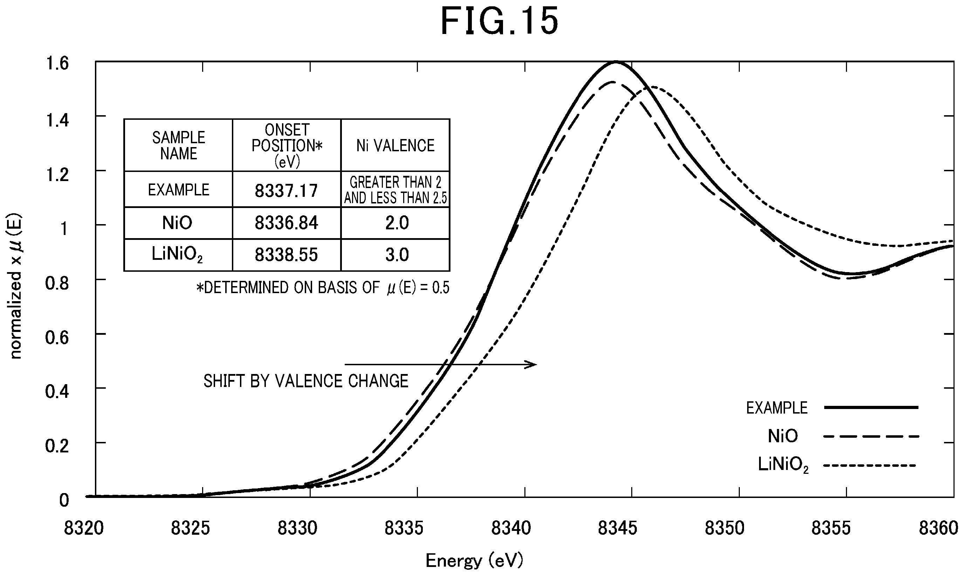

Next, the Ni valence was evaluated from the XANES spectrum of NiO created by a synthesis method of this example. Fig. 15 shows the experimental results.

As shown in Fig. 15, it was found that the XANES spectrum shifted due to changes in valence. The XANES spectrum of this example was present between the divalent NiO and the trivalent LiNiO₂. Since the Ni valence of NiO of this example was between 2 and 3 and closer to the divalent NiO, the Ni valence of this example was found to be greater than 2 and smaller than 2.5, and preferably 2.1 or greater and 2.4 or less. In the example of Fig. 15, the Ni valence is presumed to be about 2.2. This proved that the NiO of this example was a hole carrier.

In addition, a dispersion liquid of the metal oxide used for the electron transport layer of this example had a polydispersity index of less than 0.1 in a DLS measurement. Dynamic light scattering (DLS) is applied to nanoparticles floating and dispersed in the liquid. The DLS measurement is a method for calculating the particle size by measuring the diffusion speed of nanoparticles moving due to Brownian motion.

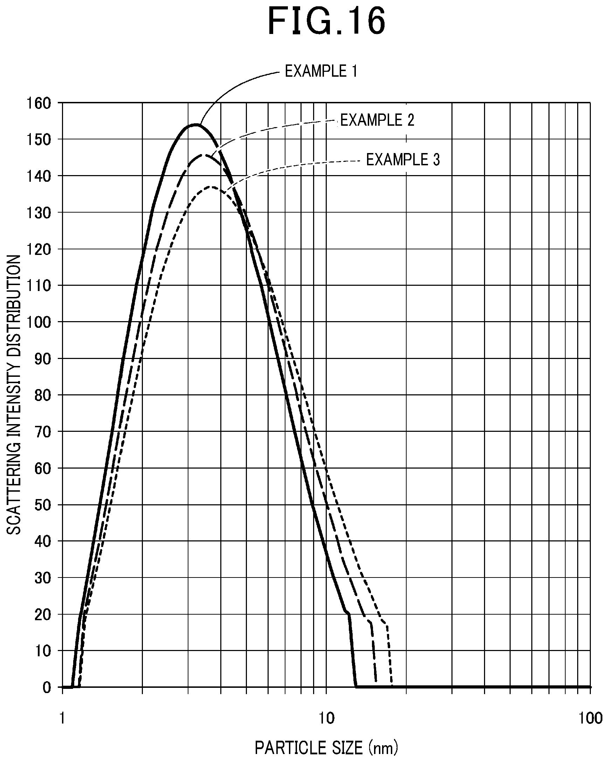

A polydispersity index (PDI) is used to express the width of particle size distribution. In the experiment, ZnO particles were prepared as the metal oxide used for the electron transport layer. Fig. 16 is a graph showing the relationships between particle size and scattering intensity distribution in respective examples. As shown in Table 2, Examples 1 to 3 each had a polydispersity index of less than 0.1. This shows that all the measured particles had substantially the same particle size in the respective examples.

**[Table 2]**

| | Sample | Number of repetitions | pH | Average particle size (nm) | Polydispersity index | Mean .(nm) | D (10%) (nm) | D (50%) (nm) | D (90%) (nm) |
|---|---|---|---|---|---|---|---|---|---|
| Example 1 | ZnO(K) | 1 | NA | 4.6 | 0.014 | 4.1 | 1.7 | 3.4 | 7.2 |
| Example 2 | ZnO(K) | 1 | NA | 4.4 | 0.007 | 4.5 | 1.8 | 3.7 | 8.2 |
| Example 3 | ZnO(K) | 1 | NA | 4.3 | 0.007 | 4.9 | 1.8 | 3.9 | 9.2 |
| | Average value | | | 4.4 | 0.009 | 4.5 | 1.8 | 3.7 | 8.2 |

The metal oxide such as ZnO or NiO is present as a film in the infrared sensor. In this embodiment, a polydispersity index of less than 0.1 enhances the dispersibility as described above, and the performance of the film can be defined by the surface roughness after film formation.

That is, the surface roughness Ra (arithmetic average roughness) of the film is preferably smaller than 1.0 nm. The surface roughness (Ra) can by analyzed using AFM measurement or the like.

### [Industrial Applicability]

According to the present invention, infrared radiation can be detected. The infrared sensor of the present invention can be applied to night vision devices, heat source detection devices, security devices, medical equipment, and the like.

The present application is based on Japanese Patent Application No. 2023-170555 filed September 29, 2023. The entire content of the application is incorporated herein by reference.

## Claims

1. An infrared sensor comprising: an electron transport layer; a light absorption layer; and a hole transport layer, wherein
the light absorption layer contains quantum dots,
the electron transport layer contains at least one of ZnO, MgZnO and SnO, and
the hole transport layer or a hole extraction layer contains at least one of NiO and MoO.

2. The infrared sensor according to claim 1, wherein
oxidation deficiency in a metal oxide constituting the electron transport layer and the hole transport layer is smaller than that in a bulk material.

3. The infrared sensor according to claim 1, wherein
the quantum dots have organic ligands on a surface, and the organic ligands include 3-mercaptopropionic acid.

4. The display device according to claim 1, wherein
the quantum dots have ligands on a surface, and the ligands have 2 or more and 5 or less carbon atoms.

5. A nanoparticle material for use in an electron transport layer constituting the infrared sensor according to claim 1, wherein
a slope of a Tauc plot of the material at an absorption edge is greater than that of a bulk material.

6. A dispersion liquid of the material according to claim 5, wherein
the dispersion liquid has a polydispersity index of less than 0.1 in a DLS measurement.

7. A method for producing the infrared sensor according to claim 1, the method comprising, in a step of forming the light absorption layer, replacing ligands after applying a composition containing the quantum dots.

8. The method for producing the infrared sensor according to claim 7, wherein,
in synthesis of the quantum dots by solution phase synthesis, quantum dots having long ligands are synthesized, and the long ligands are then replaced with short ligands before or after a composition containing the quantum dots is applied.
